(19) Europäisches Patentamt / European Patent Office / Office européen des brevets

(11) **EP 2 249 477 A1**

(12) **DEMANDE DE BREVET EUROPEEN**

(43) Date de publication:
**10.11.2010 Bulletin 2010/45**

(51) Int Cl.:
*H03H 1/00* (2006.01)　　　*H02M 7/00* (2006.01)

(21) Numéro de dépôt: **10305304.7**

(22) Date de dépôt: **25.03.2010**

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**
Etats d'extension désignés:
**AL BA ME RS**

(30) Priorité: **29.04.2009　FR 0952847**

(71) Demandeur: **Converteam Technology Ltd**
**Rugby**
**Warwickshire CV21 1BU (GB)**

(72) Inventeurs:
• **Gollentz, Bernard**
**68360 Soultz (FR)**
• **Guennegues, Virginie**
**90000 Belfort (FR)**

(74) Mandataire: **Blot, Philippe Robert Emile**
**Cabinet Lavoix**
**2, place d'Estienne d'Orves**
**75441 Paris Cedex 09 (FR)**

(54) **Système d' alimentation d'un moteur électrique comprenant un filtre passive à bobines couplées**

(57)　Ce filtre passif (20) est destiné à être agencé entre un dispositif (18) de conversion d'un courant électrique continu en un courant électrique alternatif comporte au moins une phase, et un moteur électrique (12) propre à être alimenté par le courant alternatif. Ce filtre (20) comprend, pour la ou chaque phase du courant alternatif :
- une première bobine électromagnétique (22) propre à être disposée en série du dispositif de conversion (18) et du moteur électrique (12), et comportant une borne de sortie (30) destinée à être connectée au moteur électrique (12),
- une deuxième bobine électromagnétique (24) et un condensateur (26) connectés en série l'un de l'autre, et disposés entre la borne de sortie (30) de la première bobine (22) et une masse électrique (32).
　Ce filtre passif (20) comporte, pour la ou chaque phase du courant alternatif, un noyau magnétique (34) de couplage des première et deuxième bobines électromagnétiques (22, 24), les première et deuxième bobines (22, 24) étant enroulées autour du noyau magnétique.

FIG.2

EP 2 249 477 A1

**Description**

**Filtre passif et système d'alimentation d'un moteur électrique comprenant un tel filtre**

La présente invention concerne un filtre passif destiné à être agencé entre un dispositif de conversion d'un courant électrique continu en un courant électrique alternatif comportant au moins une phase, et un moteur électrique propre à être alimenté par le courant alternatif, le filtre du type comprenant, pour la ou chaque phase du courant alternatif :

une première bobine électromagnétique propre à être disposée en série du dispositif de conversion et du moteur électrique, et comportant une borne de sortie destinée à être connectée au moteur électrique,

- une deuxième bobine électromagnétique et un condensateur connectés en série l'un de l'autre, et disposés entre la borne de sortie de la première bobine et une masse électrique,

L'invention concerne également un système d'alimentation d'un moteur électrique avec un courant électrique alternatif comportant au moins une phase, ledit système comprenant un tel filtre passif.
L'invention concerne également une chaîne électrique motrice comprenant un moteur électrique et un tel système d'alimentation du moteur électrique.
Un filtre passif du type précité est décrit dans l'article «Medium voltage three-level inverter for high speed applications» de Jörg Janning et de Jean-Charles Mercier, publié dans le compte-rendu de la 12ème Conférence Européenne sur l'Electronique de puissance et ses applications (EPE 2007 - European Conference on Power Electronics and Applications) qui s'est tenue du 2 au 5 septembre 2007. Un tel filtre comporte une structure dite L-LC.
Toutefois, des valeurs élevées d'inductances sont choisies pour les première et deuxième bobines électromagnétiques d'un tel filtre, afin de limiter le courant harmonique en sortie du dispositif de conversion, ce qui entraîne un encombrement et un coût importants des première et deuxième bobines électromagnétiques.
L'invention a pour but de proposer un filtre passif d'encombrement réduit, engendrant une faible chute de tension à ses bornes, tout en permettant de limiter les harmoniques de courant en sortie du dispositif de conversion.
A cet effet, l'invention a pour objet un filtre passif du type précité, **caractérisé en ce qu**'il comporte, pour la ou chaque phase du courant alternatif, un noyau magnétique de couplage des première et deuxième bobines électromagnétique, les première et deuxième bobines étant enroulées autour du noyau magnétique.
Suivant d'autres modes de réalisation, le filtre passif comprend une ou plusieurs des caractéristiques suivantes, prises isolément ou suivant toutes les combinaisons techniquement possibles :

- le filtre comporte, pour la ou chaque phase du courant alternatif, une résistance disposée en parallèle de la deuxième bobine électromagnétique,
- les première et deuxième bobines électromagnétiques sont enroulées de manière successive le long du noyau magnétique,
- les première et deuxième bobines électromagnétiques sont enroulées de manière concentrique l'une autour de l'autre autour du noyau magnétique.

L'invention a également pour objet un système d'alimentation d'un moteur électrique avec un courant électrique alternatif comportant au moins une phase, du type comprenant un dispositif de conversion d'un courant électrique continu en le courant électrique alternatif, et un filtre passif disposé en sortie du dispositif de conversion, et destiné à être agencé en entrée du moteur électrique, **caractérisé en ce que** le filtre passif est tel que défini ci-dessus, la première bobine électromagnétique étant disposée en série du dispositif de conversion.
Suivant d'autres modes de réalisation, le système d'alimentation comprend une ou plusieurs des caractéristiques suivantes, prises isolément ou suivant toutes les combinaisons techniquement possibles :

- le dispositif de conversion est un onduleur de tension multiniveaux, possédant un nombre quelconque de niveaux,
- le dispositif de conversion est un dispositif de conversion d'un courant électrique continu en un courant électrique alternatif comportant une pluralité (N) de phases.

L'invention a également pour objet une chaîne électrique motrice comprenant un moteur électrique et un système d'alimentation du moteur électrique, **caractérisée en ce que** le système d'alimentation est tel que défini ci-dessus.
Ces caractéristiques et avantages de l'invention apparaîtront à la lecture de la description qui va suivre, donnée uniquement à titre d'exemple, et faite en référence aux dessins annexés, sur lesquels :

- la figure 1 est une représentation schématique d'un système d'alimentation d'un moteur électrique, selon un premier mode de réalisation de l'invention, et
- la figure 2 est une vue analogue à celle de la figure 1, selon un second mode de réalisation de l'invention.

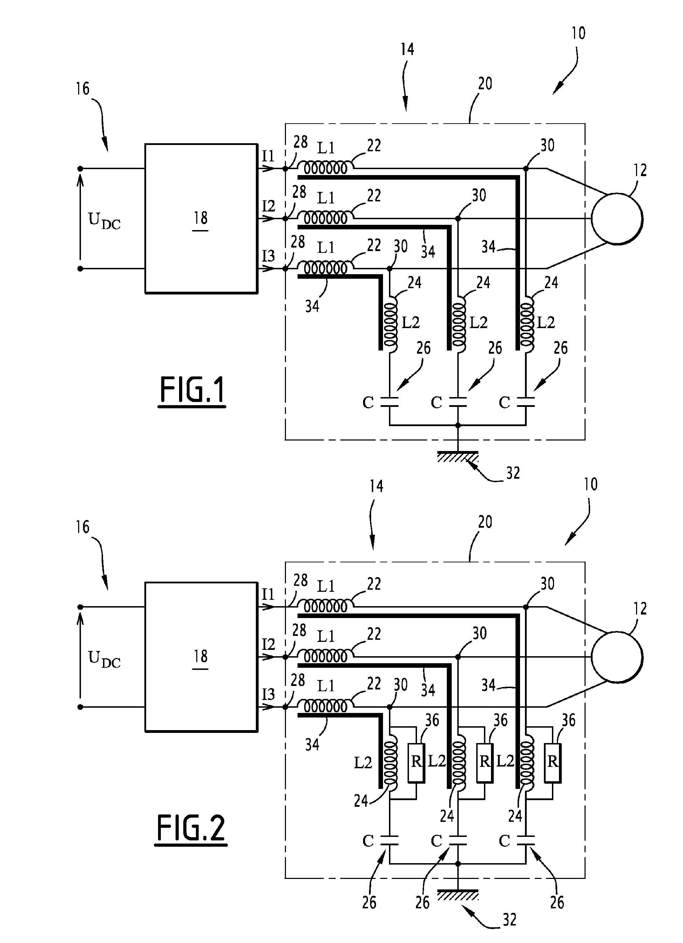

Une chaîne électrique motrice 10, illustrée sur la figure 1, comprend un moteur électrique 12 et un système 14 d'alimentation du moteur, relié à un bus 16 de circulation d'un courant continu d'entrée. Le courant continu d'entrée est de tension $U_{DC}$.

Le moteur électrique 12 est, par exemple, un moteur triphasé asynchrone. En variante, le moteur électrique 12 est un moteur triphasé synchrone.

Le système d'alimentation 14 est propre à alimenter le moteur électrique 12 avec un courant électrique triphasé. Le système d'alimentation 14 comprend un dispositif 18 de conversion d'un courant électrique continu en un courant électrique triphasé, et un filtre passif 20 disposé en sortie du dispositif de conversion 18 et en entrée du moteur électrique 12.

Dans l'exemple décrit, le dispositif de conversion 18 est un onduleur de tension multiniveaux, possédant un nombre de niveaux quelconque. Il s'agit par exemple, d'un onduleur de tension du type clampé par le neutre, ou onduleur NPC (de l'anglais Neutral Point-Clamped). En variante, il s'agit d'un type d'onduleur de tension connu, comme par exemple, une structure dite FOCH, ou encore un onduleur hybride.

Le filtre passif 20, agencé entre l'onduleur de tension 18 et le moteur électrique 12, comprend pour chaque phase du courant triphasé, une première bobine électromagnétique 22, une deuxième bobine électromagnétique 24 et un condensateur 26.

Chaque première bobine électromagnétique 22 comporte une borne d'entrée 28 connectée à une borne de sortie respective de l'onduleur de tension triphasé 18, et une borne de sortie 30 connectée à une phase d'entrée respective du moteur 12. Autrement dit, chaque première bobine 22 est disposée en série du dispositif de conversion 18 et du moteur électrique 12. Chaque première bobine 22 présente une première inductance L1.

Chaque deuxième bobine électromagnétique 24 est connectée en série avec un condensateur 26 respectif pour former un ensemble LC. Chaque ensemble LC est connecté entre la borne de sortie 30 d'une première bobine correspondante et une masse électrique 32. Chaque deuxième bobine 24 présente une deuxième inductance L2, et chaque condensateur 26 présente une capacité C.

Le filtre passif 20 comporte, pour chaque phase du courant triphasé, un noyau magnétique 34 de couplage des première et deuxième bobines électromagnétiques 22, 24, les première et deuxième bobines 22, 24 étant enroulées autour du noyau magnétique 34. Les première et deuxième bobines 22, 24 correspondant à une même phase du courant triphasé sont, par exemple, enroulées de manière successive le long du noyau magnétique 34 respectif. En variante, les première et deuxième bobines 22, 24 correspondant à une même phase du courant triphasé sont enroulées de manière concentrique l'une autour de l'autre autour du noyau magnétique 34 respectif.

Pour chaque phase du courant triphasé, l'ensemble des première et deuxième bobines 22, 24 magnétiquement couplées par le noyau de couplage 34 respectif présente une inductance mutuelle M. En considérant que le couplage magnétique entre les première et deuxième bobines 22, 24 est presque parfait, l'inductance mutuelle M s'écrit selon la formule :

$$M \approx \sqrt{L1 \times L2} \tag{1}$$

Le fonctionnement du système d'alimentation 14 va être à présent décrit.

L'onduleur de tension 18 produit des harmoniques de tension qui vont générer des harmoniques de courant. Ces harmoniques de tension sont générées à la fréquence de découpage de l'onduleur 18. Pour les onduleurs de tension de forte puissance, le filtre passif 20 est agencé en sortie de l'onduleur 18, afin de réduire les harmoniques de courant, de préférence à une augmentation de la fréquence de découpage de l'onduleur. Une augmentation de la fréquence de découpage de l'onduleur entraînerait en effet d'importantes pertes par commutation, ainsi qu'une élévation excessive de la température des composants de l'onduleur.

Chaque première bobine 22 d'inductance L1 engendre, pour chaque phase du courant triphasé, une chute $\Delta U_i$ de la tension $U_i$ entre l'onduleur 18 et le moteur 12. Chaque chute de tension $\Delta U_i$ s'écrit sous la forme :

$$\Delta U_i = L1 \times 2\pi \times f \times I_i \times \sin(\varphi_i) \tag{2},$$

où :

f représente la fréquence de rotation du moteur 12,

$I_i$ est l'intensité du courant de la phase correspondante, et

$\varphi_i$ représente le déphasage entre la tension $U_i$ et la courant $I_i$ pour la phase respective de l'onduleur 18.

Chaque condensateur 26 permet d'augmenter la tension de la phase correspondante aux bornes du moteur 12, et donc de compenser au moins partiellement la chute de tension $\Delta U_i$ due à la première inductance L1 correspondante. Toutefois, lorsque l'onduleur de tension 18 est mis hors tension, une excitation du moteur 12 peut alors être entretenue par les condensateurs 26. Les condensateurs 26 engendrent donc un risque d'auto-excitation du moteur 12 et d'augmentation anormale de la tension du moteur 12.

Le choix de la valeur de la capacité C de chaque condensateur 26 est donc un compromis entre la compensation de la chute de tension $\Delta U_i$ d'une part, et le risque d'auto-excitation du moteur 12 d'autre part.

L'impédance $Z_h$ aux fréquences des harmoniques de tension vue par l'onduleur 18, avec le filtre 20 selon l'invention, s'écrit sous la forme :

$$Z_h = (L1 + L2 + 2 \times M) \times \omega \approx (L1 + L2 + 2 \times \sqrt{L1 \times L2}) \times \omega \qquad (3),$$

où $\omega = 2 \times \pi \times f_h$, $f_h$ étant la fréquence de l'harmonique correspondante. Avec un filtre passif classique présentant la structure dite L-LC, l'impédance aux fréquences des harmoniques de tension vue par l'onduleur s'écrit sous la forme $(L1 + L2) \times \omega$. Or, plus l'impédance $Z_h$ est élevée, plus les harmoniques de courant sont limitées.

Le choix des valeurs des première et deuxièmes inductances L1, L2 est un compromis entre une réduction des harmoniques de courant et une réduction de l'encombrement des première et deuxième bobines 22, 24.

Ainsi, lorsque le compromis est réalisé en faveur d'une réduction des harmoniques de courant, le filtre passif 20 selon l'invention permet, de par la valeur plus importante de l'impédance $Z_h$, de réduire les harmoniques de courant, pour des valeurs de première et de deuxième inductances L1, L2 identiques à celles d'un filtre classique.

Lorsque le compromis est réalisé en faveur d'une réduction de l'encombrement des première et deuxième bobines 22, 24, le filtre selon l'invention permet, de par la valeur plus importante de l'impédance $Z_h$, de diminuer les valeurs des premières et deuxième inductances L1, L2, pour des harmoniques de courant identiques à ceux d'un filtre classique. Cette réduction de la valeur des première et deuxième inductances L1, L2 permet alors de réduire l'encombrement des première et deuxième bobines 22, 24, ainsi que celui du filtre 20 par conséquent.

En permettant de réduire la valeur de la première inductance L1 tout en conservant des harmoniques de courant de faible valeur, le filtre passif selon l'invention permet également de réduire la chute de tension $\Delta U_i$ à ses bornes, pour chaque phase du moteur 12.

La figure 2 illustre un deuxième mode de réalisation de l'invention pour lequel les éléments analogues au premier mode de réalisation, décrit précédemment, sont repérés par des références identiques, et ne sont donc pas décrits à nouveau.

Selon le deuxième mode de réalisation, le filtre passif 20 comprend en outre, pour chaque phase du courant triphasé, une résistance 36 disposée en parallèle de la deuxième bobine électromagnétique 24 correspondante. Chaque résistance 36 présente une impédance R.

Le fonctionnement de ce deuxième mode de réalisation est identique à celui du premier mode de réalisation, et n'est donc pas décrit à nouveau.

Les avantages de ce deuxième mode de réalisation comprennent ceux du premier mode de réalisation. Les résistances 36 permettent en outre d'amortir le filtre 20 selon ce deuxième mode de réalisation.

Les résistances 36 permettent également d'augmenter l'impédance $Z_h$ du filtre 20 vue par l'onduleur 18 pour une faible augmentation de l'encombrement, de sorte que les harmoniques de courant sont encore réduites.

L'homme du métier comprendra que l'invention, décrite dans les modes de réalisation précédents pour un dispositif de conversion d'un courant électrique continu en un courant électrique triphasé, s'applique plus généralement à un dispositif de conversion d'un courant électrique continu en un courant électrique alternatif comportant une pluralité N de phases. Dans ce cas, le filtre 20 comporte N premières bobines 22, N deuxièmes bobines 24, N condensateurs 26, et N noyaux magnétiques 34 de couplage des premières et deuxièmes bobines 22, 24 respectives.

On conçoit ainsi que l'invention permet de proposer un filtre d'encombrement et de coût réduit, engendrant une faible chute de tension à ses bornes, tout en permettant de limiter les harmoniques de courant en sortie du dispositif de conversion.

**Revendications**

1. Système (14) d'alimentation d'un moteur électrique (12) avec un courant électrique alternatif comportant au moins une phase, du type comprenant :

   - un dispositif (18) de conversion d'un courant électrique continu en le courant électrique alternatif,
   - un filtre passif (20) disposé en sortie du dispositif de conversion (18), destiné à être agencé en entrée du moteur électrique (12), et comprenant, pour la ou chaque phase du courant alternatif :
   - une première bobine électromagnétique (22) disposée en série du dispositif de conversion (18) et du moteur électrique (12), et comportant une borne de sortie (30) destinée à être connectée au moteur électrique (12),
   - une deuxième bobine électromagnétique (24) et un condensateur (26) connectés en série l'un de l'autre, et disposés entre la borne de sortie (30) de la première bobine (22) et une masse électrique (32),
   **caractérisé en ce que** le filtre passif (20) comporte, pour la ou chaque phase du courant alternatif, un noyau magnétique (34) de couplage des première et deuxième bobines électromagnétiques (22, 24), les première et deuxième bobines (22, 24) étant enroulées autour du noyau magnétique.

2. Système (14) selon la revendication 1, **caractérisé en ce que** le filtre passif (20) comporte, pour la ou chaque phase du courant alternatif, une résistance (36) disposée en parallèle de la deuxième bobine électromagnétique (24).

3. Système (14) selon la revendication 1 ou 2, **caractérisé en ce que** les première et deuxième bobines électromagnétiques (22, 24) sont enroulées de manière successive le long du noyau magnétique (34).

4. Système (14) selon la revendication 1 ou 2, **caractérisé en ce que** les première et deuxième bobines électromagnétiques (22, 24) sont enroulées de manière concentrique l'une autour de l'autre autour du noyau magnétique (34).

5. Système (14) selon l'une quelconque des revendications précédentes, **caractérisé en ce que** le dispositif de conversion (18) est un onduleur de tension multiniveaux, possédant un nombre quelconque de niveaux.

6. Système (14) selon l'une quelconque des revendications précédentes, **caractérisé en ce que** le dispositif de conversion (18) est un dispositif de conversion d'un courant électrique continu en un courant électrique alternatif comportant une pluralité (N) de phases.

7. Chaîne électrique motrice (10) comprenant un moteur électrique (12) et un système (14) d'alimentation du moteur électrique (12), **caractérisée en ce que** le système d'alimentation (14) est conforme à l'une quelconque des revendications précédentes.

FIG.1

FIG.2

Europäisches
Patentamt

European
Patent Office

Office européen
des brevets

**RAPPORT DE RECHERCHE EUROPEENNE**

Numéro de la demande

EP 10 30 5304

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2006/220972 A1 (SAITOH YOSHIHIRO [JP]) 5 octobre 2006 (2006-10-05) * figure 1 * ----- | 1-7 | INV. H03H1/00 H02M7/00 |
| Y | US 2004/066253 A1 (LAURI PASI MATTI [FI]) 8 avril 2004 (2004-04-08) * figure 1 * ----- | 1-7 | |
| Y,D | JANNING J ET AL: "Medium voltage three-level inverter for high speed applications" 2007 EUROP. CONF. ON POWER ELECTRONICS AND APPLICATIONS, EPE, 5 septembre 2007 (2007-09-05), XP002549299 ISBN: 9789275815108 * figure 4 * ----- | 1-7 | |
| A | HAMILL D C ET AL: "A 'zero' ripple technique applicable to any DC converter" POWER ELECTRONICS SPECIALISTS CONFERENCE, 1999. PESC 99. 30TH ANNUAL I EEE CHARLESTON, SC, USA 27 JUNE-1 JULY 1999, PISCATAWAY, NJ, USA,IEEE, US, vol. 2, 27 juin 1999 (1999-06-27), pages 1165-1171, XP010346825 ISBN: 9780780354210 * figure 1 * ----- | 1-7 | |
| A | US 6 452 819 B1 (WOBBEN ALOVS [DE]) 17 septembre 2002 (2002-09-17) * figure 2 * ----- | 1-7 | |

| DOMAINES TECHNIQUES RECHERCHES (IPC) |
|---|
| H03H H02M |

Le présent rapport a été établi pour toutes les revendications

| Lieu de la recherche | Date d'achèvement de la recherche | Examinateur |
|---|---|---|
| Munich | 6 mai 2010 | Schnabel, Florian |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 10 30 5304

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-05-2010

| Document brevet cité au rapport de recherche | | Date de publication | Membre(s) de la famille de brevet(s) | | | Date de publication |
|---|---|---|---|---|---|---|
| US 2006220972 | A1 | 05-10-2006 | CN | 1841894 | A | 04-10-2006 |
| | | | JP | 4219907 | B2 | 04-02-2009 |
| | | | JP | 2006287427 | A | 19-10-2006 |
| | | | KR | 20060105683 | A | 11-10-2006 |
| US 2004066253 | A1 | 08-04-2004 | AU | 2003299436 | A1 | 04-05-2004 |
| | | | WO | 2004034546 | A1 | 22-04-2004 |
| US 6452819 | B1 | 17-09-2002 | AT | 315843 | T | 15-02-2006 |
| | | | AU | 758259 | B2 | 20-03-2003 |
| | | | AU | 6342799 | A | 14-09-2000 |
| | | | BR | 9909183 | A | 05-12-2000 |
| | | | CA | 2310391 | A1 | 25-08-2000 |
| | | | DE | 19908124 | A1 | 07-09-2000 |
| | | | DK | 1078445 | T3 | 22-05-2006 |
| | | | WO | 0051225 | A1 | 31-08-2000 |
| | | | EP | 1078445 | A1 | 28-02-2001 |
| | | | ES | 2253918 | T3 | 01-06-2006 |
| | | | HK | 1034818 | A1 | 07-04-2006 |
| | | | JP | 3571654 | B2 | 29-09-2004 |
| | | | JP | 2002538752 | T | 12-11-2002 |
| | | | NZ | 504757 | A | 28-03-2003 |
| | | | TR | 200001595 | T1 | 22-01-2001 |

EPO FORM P0460

Pour tout renseignement concernant cette annexe : voir Journal Officiel de l'Office européen des brevets, No.12/82